# EUROPEAN PATENT APPLICATION

(11) **EP 2 053 664 A2**
(43) Date of publication of application: **29.04.2009**
(21) Application number: 08167332.9
(22) Date of filing: 22.10.2008
(51) Int. Cl.: H01L 31/18, H01L 21/66

(54) **Photovoltaic fabrication process monitoring and control using diagnostic devices**

(30) Priority: 22.10.2007 US 876346; 07.04.2008 US 43060 P; 17.09.2008 US 212594
(71) Applicant: Applied Materials, Inc., Santa Clara, CA 95054 (US)
(72) Inventor: Wang, Dapeng, Santa Clara, CA 95050 (US)
(74) Representative: Zimmermann & Partner

(57) **Abstract**

The formation of diagnostic devices on the same substrate used to fabricate a photovoltaic (PV) cell is described. Such devices, also referred to as process diagnostic vehicles (PDVs), are configured for in-line monitoring of electrical characteristics of PV cell features and are formed on the substrate using the same process steps for PV cell fabrication. The data collected via the PDVs can be used to tune or optimize subsequent PV cell fabrication, *i.e*., used as feedback for the fabrication process. Alternatively, the data collected via PDVs can be fed forward in the fabrication process, so that later process steps performed on a PV cell substrate can be modified to compensate for issues detected on the PV cell substrate via the PDVs.

## Description

### Field of the Invention

Embodiments of the present invention relate generally to photovoltaic devices, and more specifically to a method of fabricating and testing a solar cell that has diagnostic devices formed thereon.

### Background of the Invention

As the photovoltaic industry matures, there is a growing need for increased process control in the production of solar cells. Tighter process control can improve yield and allow scaling of current fabrication processes to larger substrates. To cost effectively and efficiently form multiple solar cell devices, various solar cell formation process parameters throughout the fabrication process need to be effectively controlled. To date, the information provided by in-line testing is limited to the performance of finished photovoltaic devices, making root-cause analysis of a poorly performing or malfunctioning solar cell challenging. The data collected by the current in-line testing is also generally not sufficient to fully understand and characterize a formed solar cell device.

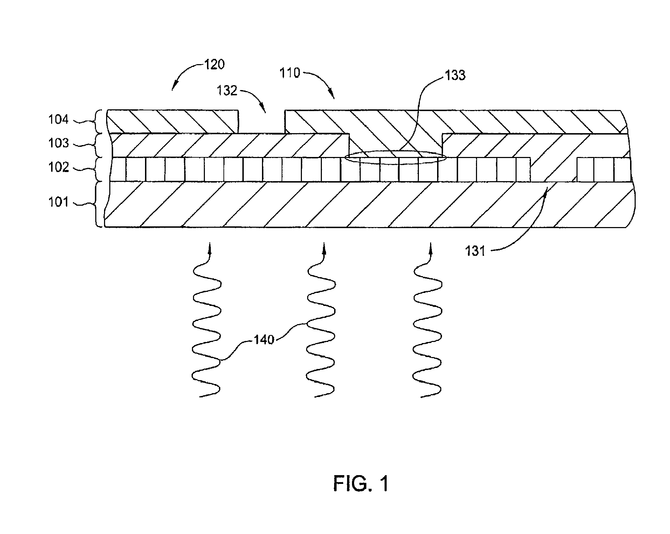

Figure 1 is a partial cross-sectional schematic diagram of photovoltaic (PV) devices 110, 120 disposed adjacent each other on a glass substrate 101. Each of PV devices 110, 120 are formed by the deposition and selective removal of portions of one or more regions of the deposited thin films, including a transparent conductive oxide (TCO) film 102, a silicon absorber layer 103, and a backside contact layer 104. TCO film 102 is an optically transparent, electrically conductive film, such as PVD-deposited ZnO, and serves as a front electrode for PV devices 110, 120. Silicon absorber layer 103 is a silicon film that includes one or more p-i-n junctions, which convert the energy from incident photons 140 to electricity through the PV effect. Several types of silicon films may be utilized to form the p-type, intrinsic type, and n-type layers of silicon absorber layer 103, such as microcrystalline silicon, amorphous silicon, polycrystalline silicon, and the like. Backside contact layer 104 serves as the back contact or electrode for PV devices 110, 120, and includes one or more conductive layers, such as PVD-deposited zinc (Zn), tin (Sn), aluminum (Al), copper (Cu), silver (Ag), nickel (Ni) and vanadium (V), zinc oxide (ZnO), or nickel vanadium alloy (NiV), among others.

Although formed together on glass substrate 101, the PV devices 110 and 120 are isolated from each other by insulating groove 131 formed in TCO film 102 and by insulating groove 132 formed in backside contact layer 104. Insulating groove 131 and insulating groove 132 are formed by the removal of portions of TCO film 102 and backside contact layer 104, respectively. Similarly, a contact region 133 is formed in silicon absorber layer 103 by the removal of a portion of silicon absorber layer 103 prior to the deposition of backside contact layer 104, so that backside contact layer 104 is in electrical contact with TCO film 102. Contact region 133 may be a single relatively large groove or area, as shown, to provide ample contact area between TCO film 102 and backside contact layer 104. In some cases, contact region 133 may be formed by a plurality of smaller grooves, for example when laser scribing is used to form contact region 133.

A number of factors can deleteriously affect the performance of PV devices 110, 120. Misalignment between insulating groove 131, insulating groove 132, and contact region 133 is one such factor. High electrical resistance in contact region 133 is another, since high contact resistance reduces the efficiency of PV devices 110, 120. Poor electrical isolation between PV devices 110, 120, can allow lateral current flow, for example when backside contact layer 104 material is not completely removed from insulating groove 132, or when TCO film 102 is not completely removed from insulating groove 131. High electrical resistance in backside contact layer 104 and/or TCO film 102 will also reduce PV device efficiency. However, because in-line testing can only provide total performance data of a PV cell, trouble-shooting which factor or combination of factors is affecting performance is difficult, time-consuming, and in many cases not easy to quantify. Thus, a large number of poor performance PV cells may be produced before the fabrication process can be optimized or altered to produce PV cells that perform within a desired range.

In light of the above, there is a need in the art for a method of fabricating a PV cell that allows the collection of diagnostic information related to PV cell performance.

### SUMMARY OF THE INVENTION

At least part of the problems in the art is solved by the method and the testing die according to the independent claims. Further embodiments, aspects and details are apparent from the dependent claims, the description and the drawings.

One embodiment of the present invention sets forth a method of fabricating a photovoltaic cell, comprising forming one or more light absorbing layers over a surface of a substrate, depositing a conductive layer over the one or more light absorbing layers, forming one or more diagnostic devices on a region of the substrate by removing at least a portion of the conductive layer, sectioning the substrate into a first and a second section after forming the one or more diagnostic devices, wherein the region is positioned substantially within the first section, and forming a photovoltaic cell using the one or more light absorbing layers and the conductive layer disposed on the second section of the substrate.

Embodiments of the invention may further provide a method of fabricating a photovoltaic cell, comprising depositing a first conductive layer over a surface of a substrate, forming one or more light absorbing layers over the first conductive layer, removing material from the one or more light absorbing layers to form one or more first isolation grooves, depositing a second conductive layer over the one or more light absorbing layers and the one or more first isolation grooves, removing a portion of the one or more light absorbing layers and a portion of the second conductive layer to substantially electrically isolate a first region of the one or more light absorbing layers from a second region of the one or more light absorbing layers, and form one or more second isolation grooves that form a third region and a fourth region within the first region which are separated by the one or more second isolation grooves, measuring the resistance between a point on the second conductive layer in the third region and a point on the second conductive layer in the fourth region, and adjusting one or more of the process parameters used to form the one or more light absorbing layers or the second conductive layer on a surface of another substrate.

Embodiments of the invention may further provide a method of fabricating a photovoltaic cell, comprising forming one or more light absorbing layers over a surface of a substrate, depositing a conductive layer over the one or more light absorbing layers, forming a first diagnostic device within a first region of the substrate, wherein forming the first diagnostic device comprises removing a portion of the one or more light absorbing layers and a portion of the conductive layer to form a second region and a third region within the first region, forming a second diagnostic device within the first region of the substrate, wherein forming the second diagnostic device comprises removing a portion of the deposited one or more light absorbing layers before depositing the conductive layer to form a first groove, removing a portion of the one or more light absorbing layers and a portion of the conductive layer to form a fourth region and a fifth region within the first region, and sectioning the substrate into a first and a second section, wherein the first region is positioned substantially within the first section.

Embodiments of the invention may further provide a method of fabricating a photovoltaic cell, comprising depositing a conductive layer on a surface of a first dielectric substrate, removing a portion of the deposited conductive layer from the surface of the first dielectric substrate to substantially electrically isolate a first region of the conductive layer from a second region of the conductive layer, measuring the electrical resistance from a point in the first region and a point in the second region, and adjusting one or more of the process parameters used of remove the portion of the deposited conductive layer to improve the resistance between a third region and a fourth region formed by removing a portion of a deposited conductive layer disposed on a surface of a second dielectric substrate.

Embodiments of the invention may further provide a method of fabricating a photovoltaic cell, comprising depositing a first layer on a surface of a first substrate, removing material from the deposited layer by forming an array of first grooves using a first scribing device, removing material from the deposited layer by forming an array of second grooves that are positioned adjacent to the array of first grooves using a second scribing device, analyzing the distance between the array of first grooves and the array of second grooves to determine an offset distance, and adjusting the position of an array of third grooves formed by the first scribing device or an array of fourth grooves formed by the second scribing device formed in a second substrate based on the determined offset distance.

Embodiments of the invention may further provide a method of fabricating a photovoltaic cell, comprising forming one or more light absorbing layers over a surface of a substrate, depositing a conductive layer over the one or more light absorbing layers, removing a portion of the one or more light absorbing layers and a portion of the conductive layer to separate a first region from a second region on the surface of the substrate, removing material from the first region to form a third region and a fourth region that are separated by the removed material, measuring the resistance between a first point on the conductive layer in the third region, and a second point on the conductive layer in the third region or a third point on the conductive layer in the fourth region, and adjusting one or more of the process parameters used to form the one or more light absorbing layers or the one or more of the process parameters used to form the conductive layer on a surface of another substrate based on the measured resistance.

Embodiments of the invention may further provide a method of fabricating a photovoltaic cell, comprising depositing a first conductive layer over a surface of a substrate, forming one or more light absorbing layers over the first conductive layer, depositing a second conductive layer over the one or more light absorbing layers, forming a testing panel on a first region of the substrate, wherein forming the testing panel comprises forming a plurality of diagnostic devices within the first region of a substrate, wherein the plurality of diagnostic devices are selected from a group consisting of resistance testers, isolation testers, alignment scales, and PV cell performance testers; and sectioning the substrate into a first and a second section after forming the testing panel.

Embodiments of the invention may further provide a testing die used to characterize at least one photovoltaic cell formation processing parameter, comprising a quantum efficiency test structure formed on the first region of the substrate, and a diagnostic devices are selected from a group consisting of a resistance tester, an isolation tester, an alignment scale, and an photovoltaic cell performance tester. According to the embodiments, the formation of diagnostic devices on the same substrate used to fabricate a photovoltaic (PV) cell is described. Such devices, also referred to as process diagnostic vehicles (PDVs), are configured for in-line monitoring of electrical characteristics of PV cell features and are formed on the substrate using the same process steps for PV cell fabrication. The data collected via the PDVs can be used to tune or optimize subsequent PV cell fabrication, *i.e*., used as feedback for the fabrication process. Alternatively, the data collected via PDVs can be fed forward in the fabrication process, so that later process steps performed on a PV cell substrate can be modified to compensate for issues detected on the PV cell substrate via the PDVs.

The invention is also directed to an apparatus for carrying out the disclosed methods and including apparatus parts for performing each described method steps. These methods steps may be performed by way of hardware components, a computer programmed by appropriate software, by any combination of the two or in any other method by which the described apparatus operates. Furthermore, the invention is also directed to methods by which the described apparatus operates. It includes method steps for carrying out every function of the apparatus.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a partial cross-sectional schematic diagram of photovoltaic (PV) devices disposed adjacent each other on a glass substrate.

Figure 2A is a schematic cross-sectional diagram of a resistance tester for measuring the electrical resistance of a backside contact layer formed on a glass PV cell substrate, according to an embodiment of the invention.

Figure 2B is top view of a resistance tester, according to an embodiment of the invention.

Figure 2C is a circuit diagram illustrating the backside contact layer resistance, absorber layer resistance, and TCO film resistance of a resistance tester.

Figure 2D is a schematic cross-sectional diagram of a resistance tester formed with multiple isolation grooves, according to an embodiment of the invention.

Figure 3A is a schematic cross-sectional diagram of a resistance tester for measuring the electrical resistance of a TCO film formed on a glass PV cell substrate, according to an embodiment of the invention.

Figure 3B is a circuit diagram illustrating the resistance of an electrical path as measured by a resistance tester.

Figure 4A is a schematic cross-sectional diagram of a resistance tester for measuring the electrical resistance of the TCO-Si interface of a PV cell, according to an embodiment of the invention.

Figure 4B is a circuit diagram illustrating the resistance of an electrical path as measured by a resistance tester.

Figure 5A is a schematic cross-sectional diagram of a resistance tester for measuring the contact resistance of a PV cell formed on PV substrate, according to an embodiment of the invention.

Figure 5B is a circuit diagram illustrating the resistance of an electrical path as measured by a resistance tester.

Figure 6 is a schematic cross-sectional diagram of an isolation tester for measuring completeness of isolation grooves formed in a TCO film of a PV cell formed on a PV substrate, according to an embodiment of the invention.

Figure 7 is a schematic cross-sectional diagram of an isolation tester for measuring completeness of isolation grooves formed in a backside contact layer and an absorber layer of a PV cell formed on PV substrate, according to an embodiment of the invention.

Figure 8 illustrates a plan view of alignment scales formed on the surface of a PV cell substrate for quantifying the alignment of two different material removal processes used to fabricate a PV cell, according to an embodiment of the invention.

Figure 9A is a top view of a cell performance tester that can be formed on a PV cell substrate simultaneously with PV cells, according to an embodiment of the invention.

Figure 9B includes two schematic cross-sectional diagrams of a cell performance tester taken at section lines A-A' and B-B' in Figure 9A.

Figure 10 is a schematic top view of a block of multiple process diagnostic vehicles (PDVs) formed on a PV cell substrate.

Figure 11A is a schematic top view of a PV cell substrate having four PV cell modules arranged thereon and a plurality of PDVs positioned in the cutting space therebetween.

Figure 11B is a schematic top view of a PV cell substrate having three PV cell modules arranged thereon and a plurality of PDVs positioned in a single block.

Figure 11C is a schematic top view of a PV cell substrate having four PV cell modules arranged thereon and a plurality of PDVs positioned inside the boundaries of the PV cell modules.

Figure 11D is a schematic top view of a PV cell substrate having three PV cell modules arranged thereon and a test panel formed on one section of the PV cell substrate according to one embodiment of the invention.

Figure 11E is a schematic top view of a test panel according to one embodiment of the invention.

Figure 11F is a schematic top view of a plurality of test die formed in test module according to one embodiment of the invention.

Figure 11G is a schematic top view of an exemplary test module according to one embodiment of the invention.

Figure 12 is a flow chart summarizing a process sequence for forming PDVs on a PV cell substrate, according to an embodiment of the invention.

Figure 13 is a flow chart summarizing a process sequence in which diagnostic information obtained through PDV testers is used to optimize the fabrication process of PV cells.

Figures 14A-F illustrate schematic cross-sectional and plan views of a resistance tester at different steps in the fabrication process, according to an embodiment of the invention.

### DETAILED DESCRIPTION

Embodiments of the invention contemplate the formation of diagnostic devices on a substrate that contains at least one PV cell. Such devices, also referred to as process diagnostic vehicles (PDVs), are configured for in-line monitoring of electrical characteristics of PV cell features. It is also contemplated that data collected via testing the characteristics of the formed PDVs can be used to tune and or improve the process results for subsequent PV cells that are fabricated in the production line, *i.e*., used as feedback for the previous fabrication processes. Alternatively, the data collected via PDVs can be fed forward in the fabrication process, so that later process steps performed on a PV cell substrate can be modified to compensate for issues detected on the PV cell substrate via the PDVs. It is further contemplated that said diagnostic devices are formed on the substrate using the same process steps for PV cell fabrication, thus minimizing or eliminating any impact of PDV formation on the PV cell fabrication process. PDVs that can be fabricated on a PV cell substrate simultaneously with PV cells include resistance testers, isolation testers, alignment scales, and complete PV cell performance testers, each of which is described below.

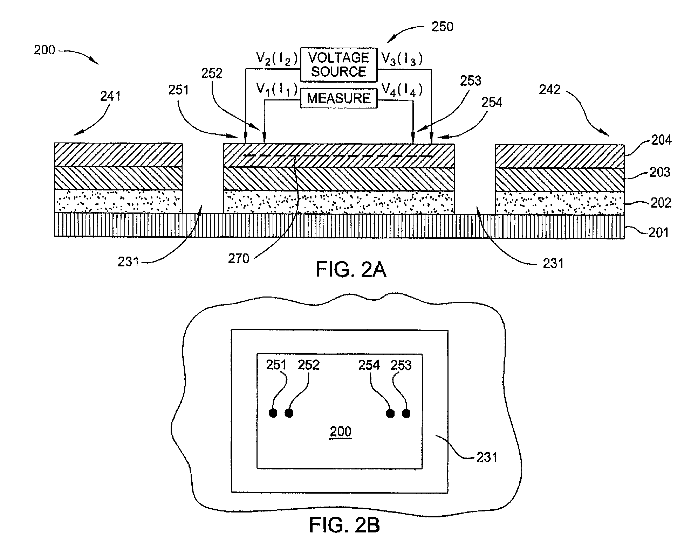

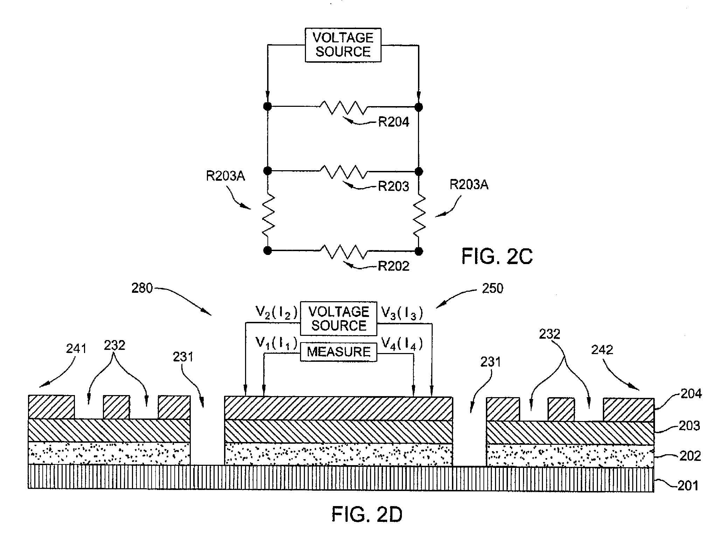

The examples of PDVs described herein relate to a single junction PV cell. However, one skilled in the art, upon reading the disclosure contained herein, will understand that the fabrication process for multi-junction PV cells can also benefit from the formation of substantially similar PDVs on a multi-junction PV cell substrate. In addition, while the discussion below primarily describes the formation of a silicon thin film solar cell device, or discusses a silicon containing absorber layer (e.g., reference numeral 203), this configuration is not intended to be limiting as to the scope of the invention, since the apparatus and methods disclosed herein could be used to test and analyze other types of solar cells, such as III-V type solar cells, thin film chalcogenide solar cells (e.g., CIGS, CdTe cells), nanocrystalline silicon solar cells, photochemical type solar cells (e.g., dye sensitized), organic type solar cells or other similar solar cell devices. The PDVs illustrated in Figures 2-9 are only intended to illustrate examples of some of the inventive types of PDVs and their general structure, and thus the shape, complexity, layer thickness and other physical attributes of each device are not intended to be limiting to the scope of the invention.

Figure 2A is a schematic cross-sectional diagram of a resistance tester 200 for measuring the electrical resistance of a backside contact layer 204 formed on a glass PV cell substrate 201, according to an embodiment of the invention. Figure 2B is top view of resistance tester 200, according to an embodiment of the invention. Similar to PV devices 110, 120 in Figure 1, resistance tester 200 includes a TCO film 202 deposited on PV cell substrate 201, an absorber layer 203 deposited on TCO film 202, and a backside contact layer 204 deposited on absorber layer 203. Active PV cells 241, 242 formed on PV cell substrate 201 are isolated from resistance tester 200 by isolation grooves 231. In one embodiment, the absorber layer 203 comprises a plurality of silicon containing layers that are used to form a portion of photovoltaic device. Isolation grooves 231 may be formed via the same material removal processes used to form the isolation grooves that form the other active PV cells on the PV cell substrate 201 (e.g., active PV cells 241, 242). The material removal processes performed by a scribing device may include conventional lithographic and etching processes, laser scribing, water jet cutting, or other similar techniques. Figure 2C is a schematic circuit diagram illustrating the backside contact layer resistance R204, the absorber layer resistance R203, the through film absorber layer resistance R203A, and the TCO film resistance R202 of resistance tester 200.

In one embodiment, the backside contact layer resistance R204 is measured by use of a measuring device 250 that probes the backside contact layer 204 using contacting points 251-254. Measuring device 250 includes a voltage source and a voltage measuring device that are connected to the contacting points 251-254. During the measurement process the measuring device 250 applies a voltage between contacting points 251, 254, so that the backside contact layer resistance R204 can be inferred from the voltage drop measured between the contacting points 252, 253. Because absorber layer resistance R203 and R203A is significantly greater than backside contact layer 204, the current primarily flows along path 270 through the backside contact layer 204 as shown, and the resistance measured by measuring device 250 is dominated by backside contact layer resistance R204. Multiple resistance testers 200 may be formed on PV cell substrate 201 in various locations and with different orientations and/or geometries, so that various regression techniques may be used to calculate more accurate values of backside contact layer resistance R204.

In one embodiment, isolation of resistance tester 200 from active PV cells 241, 242 is made more robust by forming multiple isolation grooves 232 in backside contact layer 204, as illustrated in Figure 2D. Figure 2D is a schematic cross-sectional diagram of a resistance tester 280 formed with multiple isolation grooves, according to an embodiment of the invention. Multiple isolation grooves 232 can be formed easily in backside contact layer 204 using a laser scribing type process. Because multiple isolation grooves 232 separate backside contact layer 204 of resistance tester 280 from active PV cells 241, 242, complete electrical isolation of resistance tester 280 from these adjacent devices is ensured.

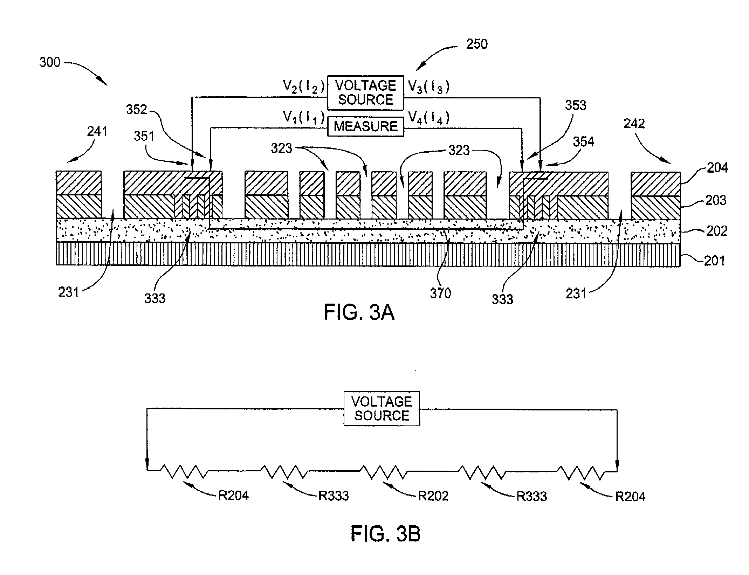

Figure 3A is a schematic cross-sectional diagram of a resistance tester 300 for measuring the electrical resistance of a TCO film 202 formed on a PV cell substrate 201, according to an embodiment of the invention. Resistance tester 300 is somewhat similar in configuration to resistance tester 200 in Figures 2A, 2B, and thus identical reference numbers for shared features are used where applicable. Resistance tester 300 may be isolated from active PV cells 241, 242, or other test structures, formed on PV cell substrate 201 by isolation grooves 231. As described above in conjunction with Figure 2A, isolation grooves 231 may include multiple grooves formed in backside contact layer 204 to ensure electrical isolation of resistance tester 300 from active PV cells 241, 242. A contact region 333 is disposed on each end of resistance tester 300 to provide a low resistance electrical path between backside contact layer 204 and TCO film 202. A single large-area portion or a plurality of smaller groove-like portions of absorber layer 203 may be removed for the formation of contact region 333. In addition, resistance tester 300 includes a plurality of inner grooves 323 formed in absorber layer 203 and backside contact layer 204 as shown. Conventional lithographic and etching processes, laser scribing, or other methods known in the art may be used to form isolation grooves 231, inner grooves 323, and contact region 333.

The TCO film resistance R202 is determined by applying a current or voltage between the contacting points 351, 354 and measuring the voltage drop between the contacting points 352, 353 using the measuring device 250 to measure the resistance. The formation of inner grooves 323, in conjunction with contact regions 333, ensures that the testing current produced by resistance tester 300 only follows electrical path 370. Figure 3B is a schematic circuit diagram illustrating the various resistances along the electrical path 370 as measured by resistance tester 300. Because the backside contact layer resistance R204 and the contact resistance R333 are significantly less than TCO film resistance R202, due to their relatively short length, the resistance of electrical path 370 is essentially equal to TCO film resistance R202, and is measured directly by measuring device 250. Multiple resistance testers 300 may be formed on PV cell substrate 201 in various locations and with different orientations and/or geometries, so that various regression techniques may be used to calculate more accurate values of TCO film resistance R202.

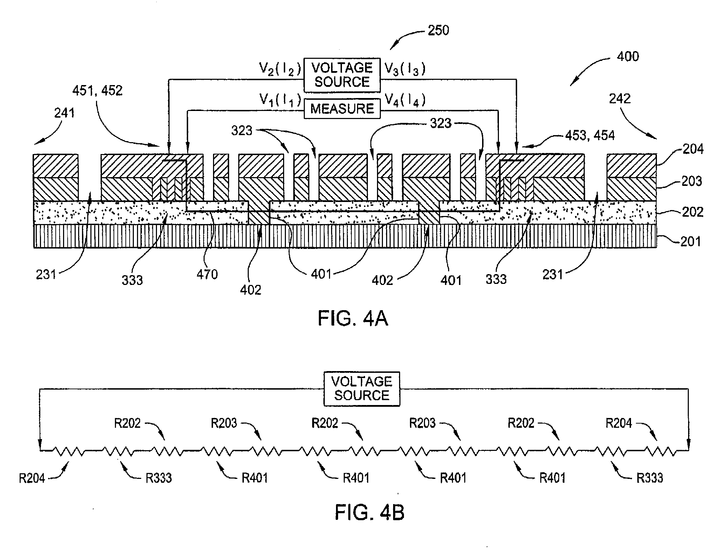

Figure 4A is a schematic cross-sectional diagram of a resistance tester 400 for measuring the electrical resistance of the TCO-Si interface of a PV cell, according to an embodiment of the invention. The configuration of resistance tester 400 is somewhat similar to resistance tester 300 in Figure 3A, and thus identical reference numbers for shared features are used where applicable. Resistance tester 400 may be isolated from active PV cells 241, 242, and other test structures, by isolation grooves 231 and a contact region 333 is disposed on each end of resistance tester 400 proximate contacting points 451, 452 and 453, 454. Portions of TCO film 202 are removed prior to deposition of absorber layer 203, so that gaps 402 are formed in TCO film 202 that are filled by absorber layer during deposition, creating part of the TCO-Si interface 401. In addition, the plurality of inner grooves 323 are located so that none of inner grooves 323 coincide with gaps 402 formed in TCO film 202. Thus, a test current flowing between contacting points 451, 454 will follow electrical path 470 through TCO film 202, the gaps 402 filled by absorber layer 203, and the TCO-Si interfaces 401 on the sides of each gap 402, as shown.

TCO-Si interfacial resistance R401 for PV cells formed on PV cell substrate 201 is determined by contacting points 451, 454 and measuring the voltage drop between the contacting points 452, 453 using a measuring device 250. As noted above, electrical path 470 passes through the TCO-Si interfaces 401 on the sides of and adjacent horizontal edges of each gap 402.
Figure 4B is a schematic circuit diagram illustrating the resistance of electrical path 470 as measured by resistance tester 400. The backside contact layer resistance R204, the contact resistance R333, and the TCO film resistance R202 are significantly less than the electrical resistance of TCO-Si interfaces 401. Similarly, when gaps 402 are relatively narrow, the electrical resistance of the portion of electrical path 470 passing through absorber layer 203 is also very small relative to the electrical resistance of TCO-Si interfaces 401. Thus, the resistance of electrical path 470 is dominated by TCO-Si interfacial resistance R401, and is measured by measuring device 250. Given the TCO-Si interfacial resistance R401 and the geometry of gaps 402, one skilled in the art can then readily measure the TCO-Si interface resistance in a PV cell formed on PV cell substrate 201. Alternatively, multiple resistance testers 400 may be formed on PV cell substrate 201 in various locations and with different orientations and/or geometries, so that various regression techniques may be used to calculate more accurate values of TCO-Si interfacial resistance R401.

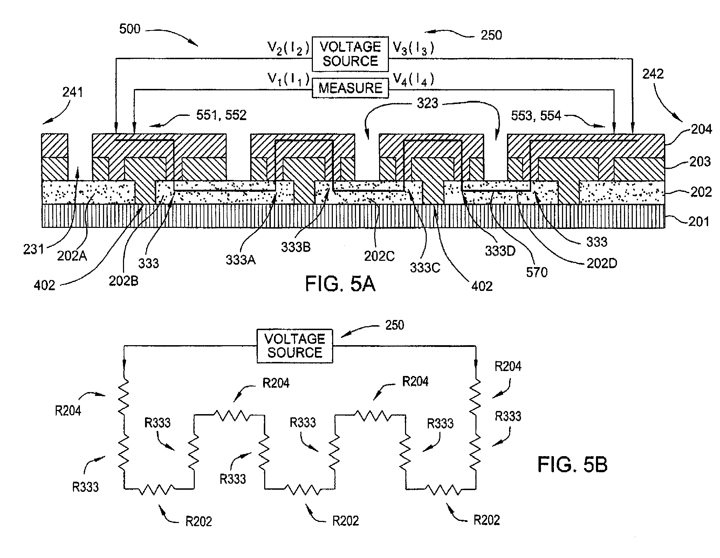

Figure 5A is a schematic cross-sectional diagram of a resistance tester 500 for measuring the contact resistance of a PV cell formed on PV cell substrate 201, according to an embodiment of the invention. The configuration of resistance tester 500 is somewhat similar to resistance tester 400 in Figure 4A, and thus identical reference numbers for shared features are used where applicable. Resistance tester 500 may be isolated from active PV cells 241, 242, and other test structures, by isolation grooves 231 and a contact region 333 that is disposed on each end of resistance tester 500 proximate contacting points 551, 552 and 553, 554. Portions of TCO film 202 are removed prior to deposition of absorber layer 203, separating TCO film 202 into a plurality of segments, *i.e*., segments 202A-E. Additional contact regions 333A-D are also formed in absorber layer 203, so that each of segments 202A-E of TCO film 202 is electrically coupled to each adjacent segment of TCO film 202 via a low-resistivity path through backside contact layer 204, as shown. Thus, a test current flowing between contacting points 551, 555 will follow electrical path 570 into segments 202A-E of TCO film 202 via contact regions 333 and additional contact regions 333A-D, as shown.

The contact resistance for PV cells formed on PV cell substrate 201, i.e. the electrical resistance of the backside contact layer/TCO film interface is determined by applying a voltage between contacting points 551, 554 and calculating the resistance by measuring the voltage drop between contacting points 552, 553 with measuring device 250. As noted above, electrical path 570 passes through multiple contact regions, *i.e*., contact regions 333 and additional contact regions 333A-D. Figure 5B is a circuit diagram illustrating the resistance of electrical path 570 as measured by resistance tester 500. Because the backside contact layer resistance R204 and the TCO film resistance R202 are significantly less than the contact resistance R333, electrical resistance of electrical path 570 will be dominated by the contact resistance R333. Thus, the resistance of electrical path 570 is essentially equal to the sum of multiple contact resistances R333, and is determined by measuring device 250. Given the resistance of electrical path 570, one skilled in the art can calculate the contact resistance of a PV cell formed on PV cell substrate 201, using an average value of contact resistance R333. Alternatively, multiple resistance testers 500 may be formed on PV cell substrate 201 in various locations and with different orientations and/or geometries, so that various regression techniques may be used to calculate more accurate values of contact resistance R333.

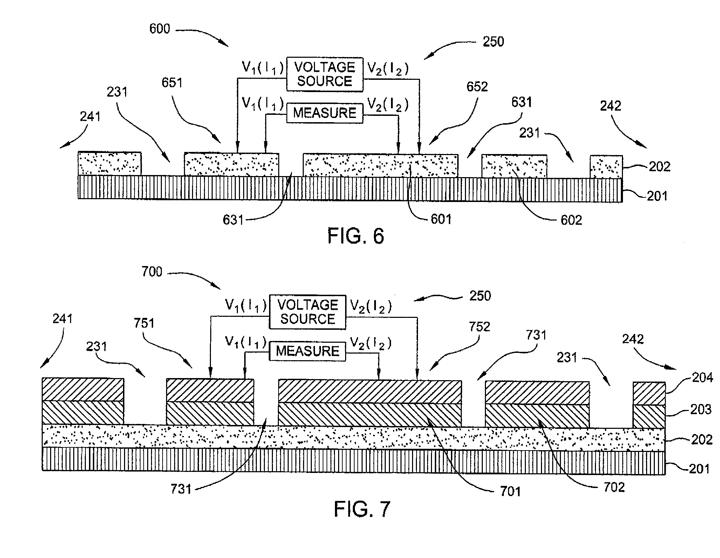

Figure 6 is a schematic cross-sectional diagram of an isolation tester 600 for measuring the effectiveness of the TCO film isolation grooves 631 formed in TCO film 202 on PV cell substrate 201 in isolating regions of the TCO film 202, according to an embodiment of the invention. When formed on PV cell substrate 201, the configuration of isolation tester 600 is somewhat similar to resistance tester 200 in Figures 2A, 2B, and thus identical reference numbers for shared features are used where applicable. Isolation tester 600 may be isolated from active PV cells 241, 242, and other test structures, by isolation grooves 231, and consists of a central region 601 that is surrounded by a peripheral region 602. TCO film isolation grooves 631 are formed between central region 601 and peripheral region 602 via the same material removal process used to form the features in TCO film 202 that are part of the PV cell fabrication process, such as insulating groove 131 in Figure 1. For example, TCO film isolation grooves 631 may be formed by conventional lithographic and etching processes, laser scribing, or other similar material removal process. In one example, the insulating grooves 231 may be formed using a laser scribe process. The insulating grooves 231 formation process using a laser scribing device can be controlled by adjusting one or more of the laser scribing process parameters that include the laser scan speed across the substrate, frequency of the pulses of energy delivered to the substrate, and output current of the laser. The laser scan speed is often dictated by manufacturing throughput requirements and is typically set at some constant value. The frequency and the output current of the laser govern the actual power produced by the laser. When performing laser scribing in various stages of the solar module fabrication, if the laser power is too low, the laser does not generate enough heat to cut through, or ablate, a respective layer. If, however, the laser power is too high, the laser cuts not only through the respective layer but may also cut or damage the layer(s) or substrate disposed underneath. Therefore, tuning the laser scribe parameters to achieve the laser power necessary to make a clean cut through a specific layer having a known or consistent deposited thickness is important.

TCO film isolation grooves 631, and thus, all other features formed on PV cell substrate 201 that include grooves or gaps formed in TCO film 202, may be characterized by contacting points 651, 652 with measuring device 250. Measuring device 250 includes a voltage source and a voltage measuring function and applies a voltage between contacting points 651, 652. Completeness of the removal of TCO film material within the TCO film isolation grooves 631 is quantified by this resistance measurement, or measurement of the current flow between the contacting points 651, 652. For example, if isolation grooves are not formed through TCO film 202 the electrical resistance between central region 601 and peripheral region 602 will be too low due to residual conductive material present at the bottom of TCO film isolation grooves 631. As with resistance testers 200, 300, 400, and 500, described above, multiple isolation testers 600 may be formed on PV cell substrate 201 in various locations and with different orientations and/or geometries to improve the accuracy of the TCO film isolation measurement.

Figure 7 is a schematic cross-sectional diagram of an isolation tester 700 for measuring completeness of TCO film isolation grooves 731 formed in backside contact layer 204 and absorber layer 203 of a PV cell formed on PV cell substrate 201, according to an embodiment of the invention. The configuration of isolation tester 700 is somewhat similar to isolation tester 600 in Figure 6, and thus identical reference numbers for shared features are used where applicable. Isolation tester 700 is isolated from active PV cells 241, 242, or other test structures, by isolation grooves 231, and consists of a central region 701 that is surrounded by a peripheral region 702. TCO film isolation grooves 731 are formed between central region 701 and peripheral region 702 via the same material removal process for forming features in backside contact layer 204 and absorber layer 203 as part of the PV cell fabrication process.

TCO film isolation grooves 731, and thus, all other features formed on PV cell substrate 201 that include grooves or gaps formed in backside contact layer 204 and absorber layer 203, may be characterized by contacting points 751, 752 with measuring device 250. Measuring device 250 includes a voltage source and a voltage measuring function and applies a voltage between contacting points 751, 752. Completeness of the removal of backside contact layer 204 from TCO film isolation grooves 731 is quantified by this resistance measurement, or measurement of the current flow between the contacting points 751, 752. As with resistance testers 200, 300, 400, and 500, described above, multiple isolation testers 700 may be formed on PV cell substrate 201 in various locations and with different orientations and/or geometries to improve the accuracy of the TCO film isolation measurement.

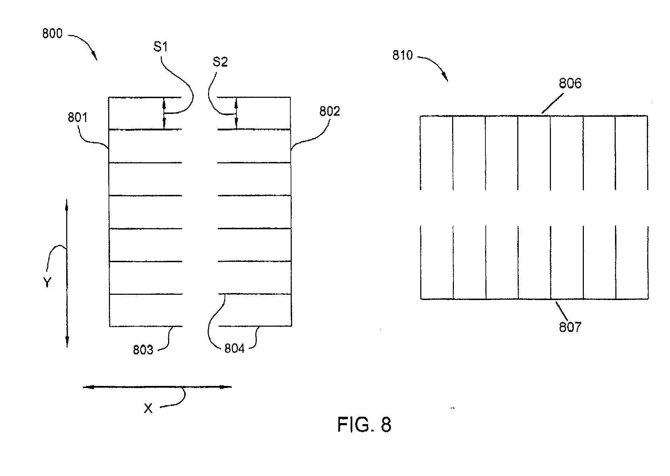

Figure 8 illustrates a plan view of alignment scales 800, 810 formed on the surface of a PV cell substrate for quantifying the alignment of two different material removal processes used to fabricate a PV cell, according to an embodiment of the invention. Alignment scale 800 includes a first scale 801 and a second scale 802, each formed by a different material removal process for PV cell fabrication. For example, first scale 801 may be formed during the removal of TCO film material and second scale 802 may be formed during the removal of absorber material. As shown, the alignment marks 803 of first scale 801 have a spacing S1, and alignment marks 804 of second scale 802 have a spacing S2 that is slightly smaller than spacing S1. Because spacing S1 and S2 are not equal, misalignment of first scale 801 and second scale 802 can be quantified to a relatively high level of precision without resorting to estimation. That is, by determining which of alignment marks 803 and 804 are equidistant from axis X, the offset along axis Y, *i.e.,* the vertical offset, between the two material removal processes can be quantified in a manner similar to that used by a vernier scale. Similarly, misalignment between two material removal processes along axis X, *i.e.,* the horizontal offset, can be quantified with an alignment scale 810. Alignment scale 810 generally includes a first scale 806 and a second scale 807, each formed by a different material removal process in the PV cell fabrication process. Alignment of alignment marks 803 to 804, or alignment marks 806 to 807, can be performed by manual inspection or in an automated fashion using a digital camera coupled to a digital image analyzing computer, or other similar digital imagery device. The measured misalignment, or offset, between two material removal processes can be quantified and then adjusted by adjusting of the position of the various material removal devices, for example, the beam position of each laser in each of the laser scribing devices. The offset between the alignment marks 803 to 804 can adjusted by manual or automated offset adjustment of the various material removal components in the material removal devices.

Because the misalignment of only two material removal processes can be quantified by a single pair of alignment scales, *i.e*., one vertical and one horizontal scale, multiple pairs of alignment scales are generally needed to quantify misalignment between each material removal process. For example, when three material removal steps are needed to fabricate a PV cell on a substrate, three pairs of alignment scales are required: the first pair of scales measures misalignment of the first step with the second step; the second pair of scales measures misalignment of the second step with the third step; and the third pair of scales measures misalignment of the first step with the third step.

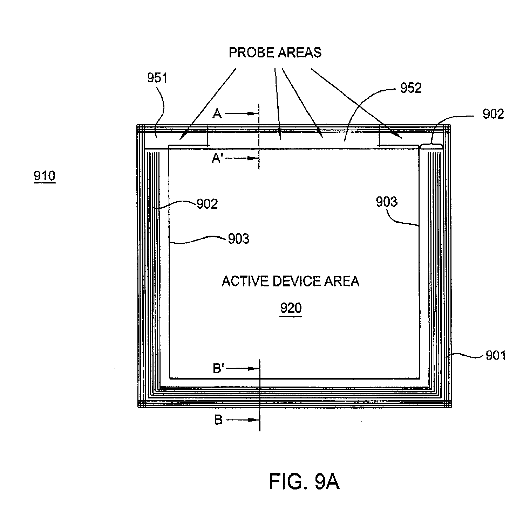

In addition to resistance testers, isolation testers, and alignment scales, other process development vehicles (PDVs) can be formed on a PV cell substrate that act as fully functional PV devices for quantifying PV cell performance on the substrate. Performance metrics that can be measured in this way include quantum efficiency (QE), dark current (DIV), light-current-voltage (LIV) and/or fill factor. Figure 9A is a top view of a cell performance tester 900 that can be formed on a PV cell substrate 910 simultaneously with product PV cells (not shown), according to an embodiment of the invention.

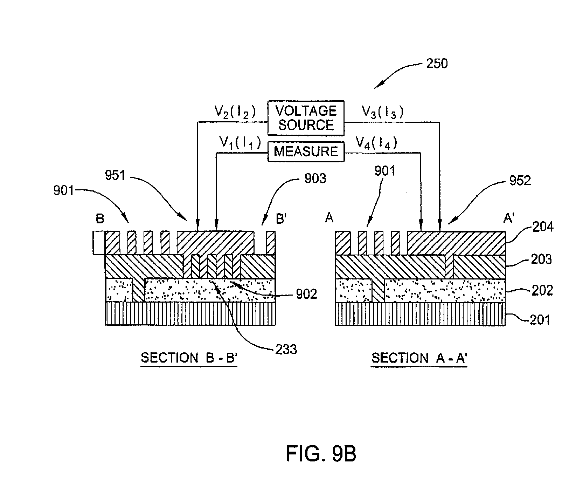

Figure 9B includes two schematic cross-sectional diagrams of cell performance tester 900 taken at section lines A-A' and B-B' in Figure 9A. Cell performance tester 900 is somewhat similar in configuration to the PDVs described above, such as resistance testers 200, 300, and 400, and thus identical reference numbers for shared features are used where applicable.

Cell performance tester 900 is defined on a region of PV cell substrate 910 by laser scribe lines 901, which are formed through backside contact layer 204 to electrically isolate cell performance tester 900 from the PV cells and other PDVs formed on PV cell substrate 910. Multiple parallel laser scribe lines 901 are used to improve electrical isolation. Cell performance tester 900 is further defined by laser scribe lines 902, which are formed through absorber layer 203 to create a contact region 233 between backside contact layer 204 and TCO film 202 (see Figure 9B). Laser scribe lines 903 define the active device area 920 of cell performance tester 900, and are formed through backside contact layer 204, as shown in Figure 9B. Laser scribe lines 903 also electrically isolate probe points 951 and 952, so that the cell performance of active device area 920 can be measured with measuring device 250. While cell performance tester 900 is described in terms of laser scribing of the different films that make up this PDV, one skilled in the art will understand that other material removal methods known in the art may also be used to form cell performance tester 900.

For measurement of cell performance parameters, measuring device 250 contacts probe points 951 and 952, as illustrated schematically in Figure 9B. When measuring DIV, *i.e*., the relatively small electric current that flows through cell performance tester 900 when no photons are incident thereon, cell performance tester 900 is performed in a dark environment. When measuring QE of cell performance tester 900, also referred to as spectrum response, measurements are typically taken with and without incident light energy on active device area 920. Monochromatic light sources of known output power, such as laser diodes, are used to illuminate active device area 920 for this testing. Single junction devices are measured at two wavelengths and triple junction devices at four. LIV testing of cell performance tester 900 can be performed to provide such solar cell parameters as short-circuit current, open-circuit voltage, and fill factor.

The presence of cell performance tester 900 on PV cell substrate 910 provides a means by which the performance of PV cells formed on PV cell substrate 910 can be accurately estimated before such PV cells have been singulated from the substrate and packaged. One of skill in the art will appreciate that cell performance tester 900 can easily be scaled to different sizes and geometries, and a plurality of cell performance testers 900 can be disposed at different locations on a given substrate to help quantify perimeter contributions to the performance of PV cells formed on the substrate.

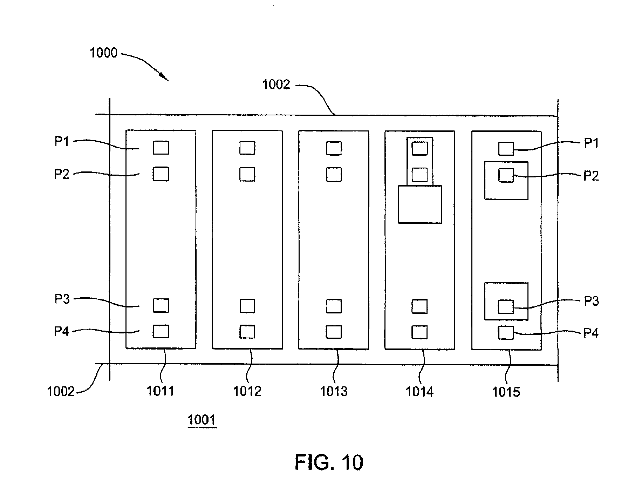

For convenience in testing, the different PDVs as described herein may be configured with similar geometries, so that the relative probe locations for each PDV have the same spacing. In this way, a single measuring device may be used to perform multiple test measurements, such as measuring device 250. Figure 10 is a schematic top view of a block 1000 of multiple PDVs formed on a PV cell substrate 1001. Block 1000 is defined by isolation gaps 1002 formed in the backside contact layer of PV cell substrate 1001. Block 1000 includes a backside contact resistance tester 1011, substantially similar in configuration to resistance tester 200 in Figure 2A, a TCO film resistance tester 1012, substantially similar in configuration to resistance tester 300 in Figure 3A, a contact resistance tester 1013, substantially similar in configuration to resistance tester 500 in Figure 5A, a cell tester 1014, substantially similar to cell performance tester 900 in Figures 9A-C, and a backside contact isolation tester 1015, substantially similar in configuration to isolation tester 700 in Figure 7.

Each of the PDVs contained in block 1000 has four probe points P1-P4, as shown, to enable four-terminal measurements. For backside contact resistance tester 1011, probe points P1-P4 correspond to contacting points 251-254, respectively, in Figure 2A. For TCO film resistance tester 1012, probe points P1-P4 correspond to contacting points 351-354, respectively, in Figure 3A. For contact resistance tester 1013, probe points P1-P4 correspond to contacting points 551-554, respectively, in Figure 5A. For cell tester 1014, probe point P1 corresponds to probe point 951 in Figure 9A and probe point P2 corresponds to probe point 952. For backside contact isolation tester 1015, probe points P1, P4 correspond to contacting point 751 in Figure 7 and probe points P2, P3 correspond to contacting point 752. Thus, a single measurement device can be translated across block 1000 and perform multiple measurements of the PDVs in block 1000 in a short time. Alternatively, a single measurement device with five four-terminal probes can contact all the probe points of block 1000 simultaneously and perform all testing at one time.

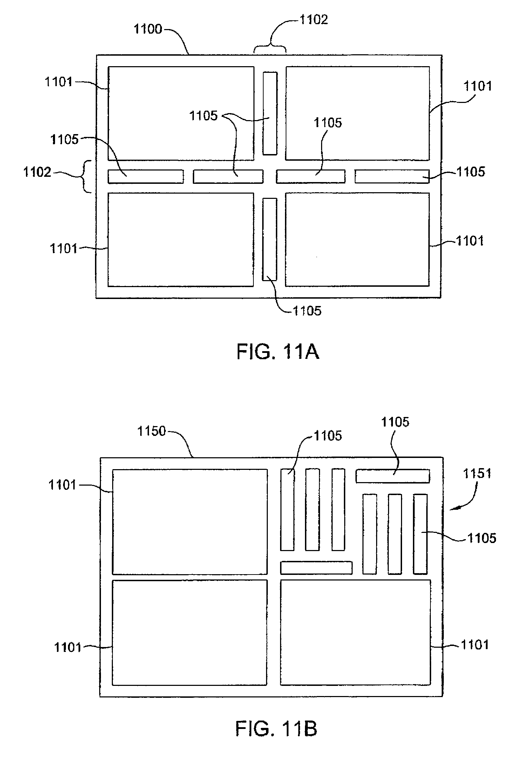

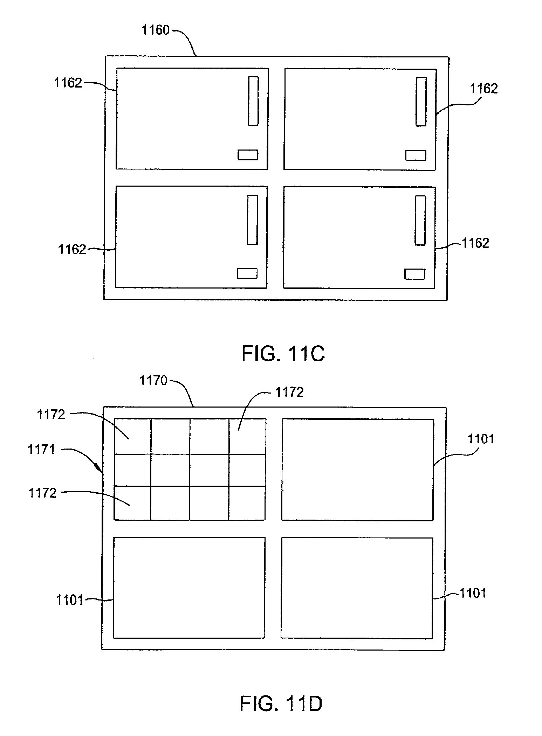

It is contemplated that the various PDVs described herein, *i.e*., resistance testers, isolation testers, alignment scales, and PV cell performance testers, can be formed on dedicated test substrates or disposed on the same substrates as product PV cells. When PDVs are formed on product substrates, PDVs may be positioned around the product PV cell modules on the substrate, grouped in one location in lieu of a PV cell module, or positioned on the surface of one or more PV cell modules. Figure 11A is a schematic top view of a PV cell substrate 1100 having four PV cell modules 1101 arranged thereon and a plurality of PDVs 1105 positioned in the cutting space 1102 between PV cell modules 1101. Figure 11B is a schematic top view of a PV cell substrate 1150 having three PV cell modules 1101 arranged thereon and a plurality of PDVs 1105 positioned in a single block 1151. Block 1151 is formed on PV cell substrate 1150 in lieu of having a fourth PV cell module. Figure 11C is a schematic top view of a PV cell substrate 1160 having four PV cell modules 1162 arranged thereon and a plurality of PDVs positioned inside the boundaries of the PV cell modules 1162.

Figure 11D is a schematic top view of a PV cell substrate 1170 having three quarter panel sized PV cell modules 1101 arranged thereon and a test panel 1171 that contains a plurality of testing modules 1172 in which a plurality of PDVs are formed. In one embodiment, PV cell modules 1101 and the test panel 1171 are quarter sections of a 2.2m x 2.6m sized solar cell substrate. The plurality of testing modules 1172 are generally formed during the steps in the process sequence used to form the three quarter panel sized PV cell modules 1101. In one embodiment, the testing module 1172 is a 30cm x 30cm section of the PV cell substrate 1170 that contains a plurality of PDVs illustrated in Figures 2-9, which are discussed above.

In one embodiment, the PV Cell processing sequence contains a substrate sectioning module that is used to section the PV cell substrate 1170 into one or more PV cell modules 1101 and one or more test panels 1171. In one embodiment, the substrate sectioning module receives a 2600 mm x 2200 mm PV cell substrate 1170 and sections it into one 1300mm x 2200 mm PV cell module 1101 and one 1300mm x 2200 mm test panel 1171. In one embodiment, the substrate sectioning module receives a 2600 mm x 2200 mm sized PV cell substrate 1170 and sections it into one 2600 mm x 1100 mm PV cell module 1101 and one 2600 mm x 1100 mm test panel 1171. In one embodiment, the substrate sectioning module receives a 2600 mm x 2200 mm PV cell substrate 1170 and sections it into three 1300 mm x 1100 mm PV cell modules 1101 and one 1300mm x 2200 mm test panel 1171 (Figure 11 D). An example of a sectioning process and module that is adapted to perform this process is further described in the United States Patent Application Serial Number 12/201,840, filed August 29, 2008, which is herein incorporated by reference.

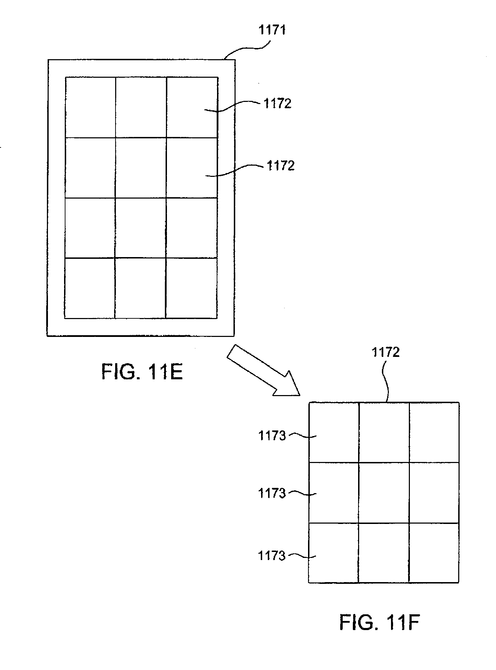

Figure 11E is a top view of one embodiment of a test panel 1171, which has nine testing modules 1172 formed thereon. Figure 11F is a close-up top view of at least one of the test panels 1171 shown in Figure 11E that contains a plurality of testing die 1173 formed thereon. Each testing die 1173 may have one or more of the PDVs formed therein, and thus provide an array of test structures that can be used to help analyze and qualify aspects of the solar cell formation process. In one embodiment, each testing die 1173 is a 10cm x 10cm section of the PV cell substrate 1170 that contains a plurality of PDVs. In one embodiment, the testing die 1173 is similarly configured as the block 1000 shown in Figure 10.

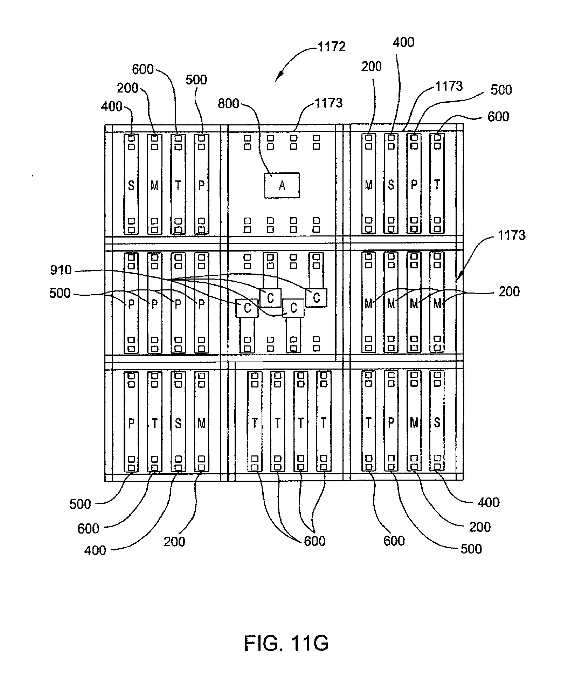

Figure 11G illustrates an exemplary layout of a testing module 1172 that contains nine testing die 1173. In this configuration, each testing die 1173 generally contains a plurality of PDVs that may be arranged as shown. In this example, each testing die 1173 contains at least one of the PDVs that are discussed above in conjunction with Figures 2-9.

### Process Flow

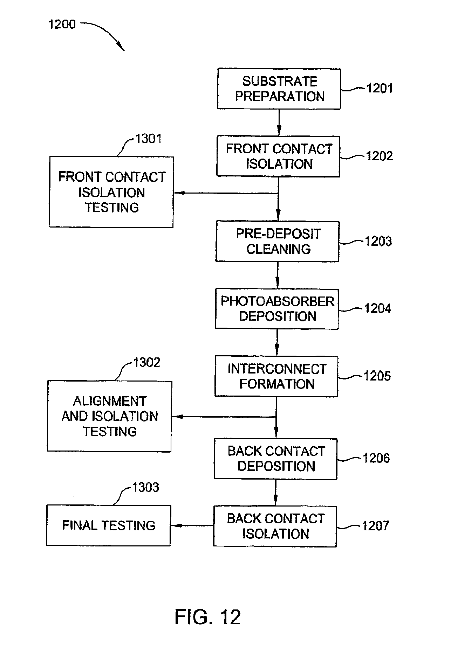

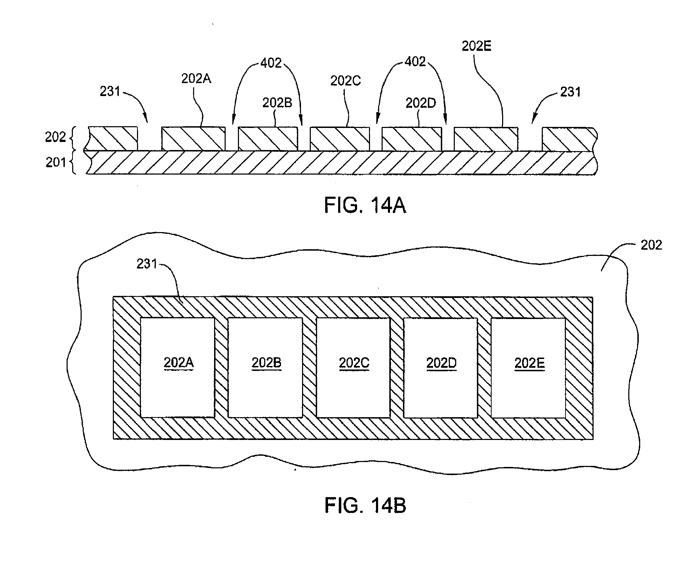

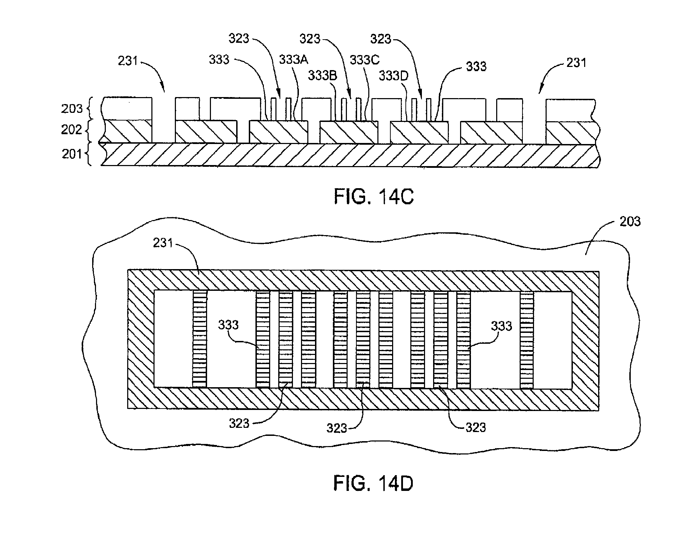

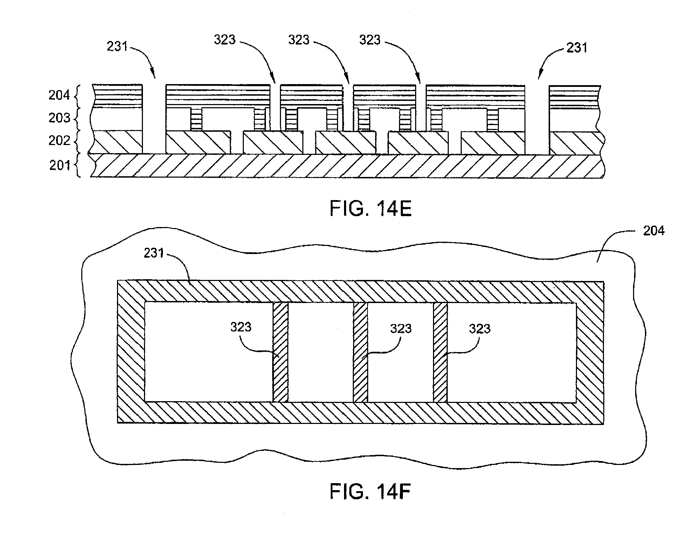

Embodiments of the invention contemplate the formation of PDVs and PV cells simultaneously on a PV cell substrate. Figure 12 is a flow chart summarizing a process sequence 1200 for forming PDVs on a PV cell substrate, according to an embodiment of the invention. By way of example, the formation of resistance tester 500 in Figure 5A is described in process sequence 1200. Figures 14A-F illustrate schematic cross-sectional (*i.*e., Figures 14A, 14C and 14E) and plan views (*i.e*., Figures 14B, 14D and 14F) of resistance tester 500 at different stages of the fabrication process. One skilled in the art will understand that the other PDVs described herein, including resistance testers, isolation testers, alignment scales, and complete PV cell performance testers, can also be formed by process sequence 1200 on a PV cell substrate.

In step 1201, a dielectric substrate, for example, a glass substrate is received and prepared for processing. In one embodiment, the substrates are received in a "raw" state, where the edges, overall size and/or cleanliness of the substrate are not well controlled. Receiving raw substrates reduces the cost to prepare and store substrates prior to forming a solar device and thus reduces the solar cell device cost, facilities costs, and production costs of the finally formed solar cell device. In this embodiment, the raw substrate has a TCO layer formed thereon. Alternatively, a TCO layer may be deposited in an additional process step. As part of preparation, the edges of the substrate are prepared in a seaming device to prevent yield issues, and the surfaces of the substrate are then cleaned using wet chemical scrubbing and rinsing steps to remove any undesirable contaminants. In one embodiment, the TCO layer is a ZnO, SnO, or AZO layer that is deposited using a plasma enhanced chemical vapor deposition (PECVD) process, hot wire chemical vapor deposition (HWCVD) process, a physical vapor deposition (PVD) process or other similar deposition process.

In step 1202, front contact isolation is performed on the substrate to electrically isolate different regions of the substrate surface from each other. In this step, TCO material is removed from the substrate surface by use of a material removal step to form gaps 402 in TCO film 202 to separate TCO film 202 into segments 202A-E, and to form the bottom of isolation grooves 231, illustrated in Figures 5A and 14A-14B. In one embodiment, a Nd:vanadate (Nd:YVO₄) laser source is used to ablate material from the substrate surface to form lines that electrically isolate one region of the substrate from the next. In another embodiment, a water jet cutting tool or diamond scribe is used to form scribe lines and thus isolate the various regions on the surface of the substrate to form PV cells and segments 202A-E of resistance tester 500. In addition, it is desirable that the temperature of the substrates entering the scribe module 208 are at a temperature in a range between about 20 °C and about 26 °C to ensure accurate location of the scribe lines. For example, an active temperature control hardware assembly may be used that may contain a resistive heater and/or chiller components (e.g., heat exchanger, thermoelectric device). In one embodiment, it is desirable to control the substrate temperature to about 25 +/- 0.5 °C.

In step 1203, the substrate undergoes a pre-deposition cleaning step to remove any contaminants from the surface of the substrate after performing front contact isolation in step 1202. The cleaning process in step 1203 may be substantially similar to the cleaning process in step 1202.

In step 1204, photoabsorber layer (e.g., absorber layer 203) deposition process takes place. One or more photoabsorber deposition steps may include one or more preparation, etching and/or material deposition steps that are used to form the various photoabsorber regions of PV cells and absorber layer 203 of resistance tester 500 in Figures 5A and 14C-14D. Step 1204 generally includes a series of sub-processing steps to form one or more p-i-n junctions. In one embodiment, the one or more p-i-n junctions comprise amorphous silicon and/or microcrystalline silicon materials. In general, the one or more processing steps are performed in one or more cluster tools to form one or more layers on the substrate surface to form at least a part of the p-i-n junction(s) of a solar cell device. Further information regarding amorphous silicon and microcrystalline silicon deposition for thin film solar applications can be found in United States Provisional Patent Application Serial No. 60/967,077, filed 08/31/07 and United States Patent Application Serial No. 12/178,289, filed July 23, 2008, which are both incorporated by reference herein. In one embodiment, the photoabsorber layer is deposited using a plasma enhanced chemical vapor deposition (PECVD) process, hot wire chemical vapor deposition (HWCVD) process, or other similar deposition process.

In step 1205, interconnect formation is performed on the substrate to form features in the absorber material. In this step, absorber material is removed from absorber layer 203 by use of a material removal step. In this way, contact regions 333, additional contact regions 333A-D, and the bottom of inner grooves 323 are formed, as illustrated in Figures 5A and 14C-D. Absorber material deposited in isolation grooves 231 during step 1204 is also removed. A laser ablation or other material removal technique, as described above in step 1202, may be used for interconnect formation in step 1205. The substrate may undergo an additional cleaning step, as described above in step 1203, after the interconnect formation of step 1205.

In step 1206, back contact deposition takes place, in which one or more substrate back contact formation steps are performed on the substrate. In one embodiment, step 1206 includes one or more PVD deposition steps that are used to form the back contact region on the surface of the substrate and backside contact layer 204 on resistance tester 500 in Figures 5A and 14E-14F. In one embodiment, the one or more PVD deposition steps are used to form a back contact region that contains a metal element selected from a group consisting of zinc (Zn), tin (Sn), aluminum (Al), copper (Cu), silver (Ag), nickel (Ni) and vanadium (V). In one example, a zinc oxide (ZnO) or nickel vanadium alloy (NiV) are used to form at least a portion of the back contact layer. The one or more processing steps may be performed using an ATON^{™} PVD 5.7 tool available from Applied Materials in Santa Clara, California. In another embodiment, the back contact region is deposited using a plasma enhanced chemical vapor deposition (PECVD) process, hot wire chemical vapor deposition (HWCVD) process, or other similar deposition process.

In step 1207, back contact isolation is performed on the substrate to electrically isolate the plurality of solar cells contained on the substrate surface from each other and to complete isolation grooves 231 and inner grooves 323 in Figures 5A and 14E-14F. In this step, backside contact material is removed by use of a material removal step. A laser ablation or other material removal technique, as described above in step 1202, may be used for back contact isolation in step 1207. The substrate may undergo an additional cleaning step, as described above in step 1203, after the interconnect formation of step 1207.

A solar cell production line capable of performing process sequence 1200 and additional processes that may be used to form a PV cell device are described in greater detail in the United States Patent Application Serial No. 12/202,199 [Attorney Docket No. 11141], filed 08/29/08, and United States Provisional Patent Application Serial No. 60/967,077, filed 08/31/07, which both have been incorporated by reference. Also, information regarding the hardware, processing methods, and deposition parameters that could be used to form one or more layers in the PV cell, such as a p-i-n junction type PV cell, is further described in United States Patent Application Serial No. 12/178,289 [Attorney docket # APPM 11709.P3], filed July 23, 2008, and United States Patent Application Serial No. 12/170,387 [Attorney docket # APPM 11710], filed July 9, 2008, which are both herein incorporated by reference. One skilled in the art will appreciate that the sequence of material deposition and removal steps described in process sequence 1200 for forming PV cells on the substrate can also be used to form PDVs on the same substrate at the same time or during the same process step. Hence, no additional process steps are required to produce the PDVs described herein on a substrate when forming PV cells.

Embodiments also contemplate the testing of a PV cell substrate during the solar cell fabrication process using PDVs formed on the substrate. In this embodiment, the electrical characteristics of partially formed PV cells and the accuracy of alignment of each material removal process can be checked, thereby providing valuable process tuning and diagnostic information. Referring to Figure 12, process steps 1301-1303 summarize exemplary PDV testing process 1200.

In step 1301, the substrate is removed from the production line for testing of the front contact isolation. One or more isolation testers similar to isolation tester 600 are measured and analyzed. In one embodiment, a four-point probe type of measurement device may be used. In one embodiment, the substrate is permanently removed from the production line. In another embodiment, the substrate may be returned to the production line for further processing and testing.

In step 1302, the substrate is removed from the production line for testing and analysis of the alignment between the front contact isolation and interconnect formation steps. One or more alignment testers similar to alignment scales 800, 810 in Figure 8 are used for this procedure. Isolation testing between the features produced by the interconnect formation step can also be performed. In one embodiment, the substrate is permanently removed from the production line. In another embodiment, the substrate may be returned to the production line for further processing and testing.

In step 1303, the substrate is removed from the production line for final testing. Final testing includes checking alignment between the front contact isolation and back contact isolation steps and between the interconnect formation and back contact isolation steps as well as measuring back contact layer resistance, TCO resistance, back contact isolation, contact resistance, and TCO-Si interface resistance, among others. Testing of cell performance testers may also be performed in step 1303.

The methods described above in conjunction with Figure 12 provide a number of advantages. First, diagnostic information can be obtained for each important parameter related to PV cell performance. In addition, when PDVs are arranged on a substrate with product PV cells, diagnostic information can be obtained from potentially every substrate that is processed by a production line. Such diagnostic information can be fed back to the appropriate step in the fabrication process to re-tune a production line, thereby addressing process drift and other out-of-spec conditions in the production line.

Moreover, diagnostic information obtained during production of PV cells can be "fed forward" in a production process to compensate for marginal or out-of-spec conditions detected earlier in the production line. Thus, substrates with partially formed PV cells thereon can be processed in a modified fashion to compensate for a measured deficiency, thereby reducing the effect of out-of-spec conditions present in the production line and reducing the number of that are scrapped.

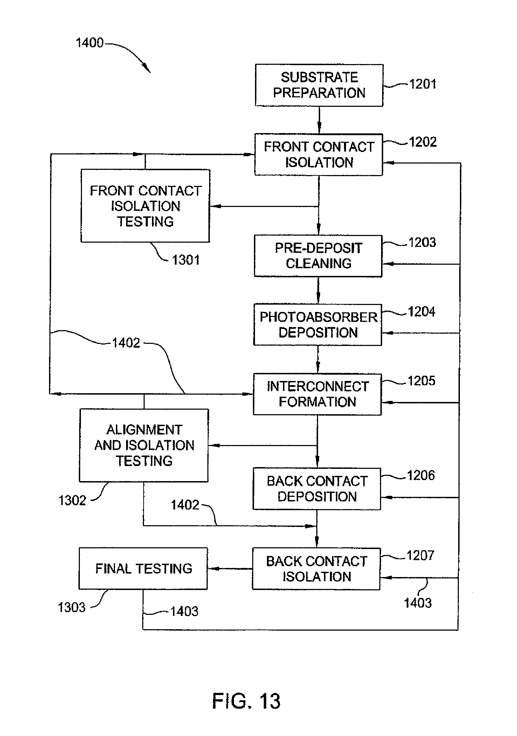

Figure 13 is a flow chart summarizing a process sequence 1400 in which diagnostic information obtained through PDV testers is used to optimize the fabrication process of PV cells. In process sequence 1400, diagnostic information from PDVs can be fed back to earlier steps in the fabrication process to improve subsequent process runs. In addition, diagnostic information from PDVs can be fed forward so that later process steps can be modified to compensate for issues detected on the PV cell substrate via the PDVs. Process sequence 1400 includes steps 1201-1207 and 1301-1303, which are described above in conjunction with Figures 12 and 13, respectively.

As shown, after step 1301, diagnostic information 1401 regarding testing of front contact isolation, *i.e*., TCO film isolation, can be fed back to step 1202. For example, if front contact isolation is inadequate, *i.e*., resistance measured across the appropriate isolation tester is too low, the front contact isolation process in step 1202 can be modified to bring properties of the later formed solar cells within the desired range. One skilled in the art will appreciate that the feed-back/feed-forward procedure can be performed in an automated or semi-automated fashion.

After step 1302, alignment information 1402 regarding relative alignment between front contact isolation features and interconnect formation features can be fed back to step 1202 and step 1205 to optimize alignment in later production runs. In addition, alignment information 1402 can be fed forward to step 1207 for the production run underway, so that partially formed PV cells can be processed with a modified back contact isolation process. For example, the position of the back contact isolation process can be shifted and/or the amount of material removed by the back contact isolation process can be increased to compensate for misalignment detected in step 1302.

Similarly, after step 1303, diagnostic information 1403 from final testing of PV cell substrates can be fed back to the appropriate process step to optimize the fabrication process in subsequent production runs. In one example, the data collected from the testing of PDVs (e.g., reference numerals 200-900) can be used to alter the PECVD, HWCVD, PVD or other similar deposition process parameters used to form the TCO film, such as process chamber pressure, processing power, substrate temperature, and/or substrate electrical bias are adjusted to improve the electrical properties of the deposited TCO film. In another example, the data collected from the testing of PDVs can be used to alter the deposition process parameters used to form the absorber layer, such as process chamber pressure, processing power, substrate temperature, and/or substrate electrical bias are adjusted to improve the electrical properties of the deposited absorber layer. In another example, the data collected from the testing of PDVs can be used to alter the deposition process parameters used to form the back contact layer, such as process chamber pressure, processing power, substrate temperature, and/or substrate electrical bias are adjusted to improve the electrical properties of the deposited back contact layer.

The methods described above in conjunction with Figure 12 and 13 may also provide a number of other advantages. First, when a software-driven laser ablation process is used as the material removal processes in process sequence 1200, a high degree of flexibility in the formation of the PDVs is available. Since photomasks are not required for the laser ablation/scribing process, the configuration, size, location, and orientation of PDV testers can be modified at any time. For example, if a problem is suspected with contact resistance, a suite of contact resistance testers can be processed between production runs without the need for developing a series of specialized masks.

Second, optimization of process design rules and other process parameters can be determined using a series of testers for the feature or process parameter in question. For example, to determine the optimum spacing between insulating groove 131 and insulating groove 132 of PV devices 110, 120 in Figure 1, a series of testers with varying spacing can be formed on a PV cell substrate in an automated, e.g., software-based, fashion. In this way, the optimum trade-off between performance and yield of PV devices 110, 120 can be quantitatively determined quickly and without the need for a series of specialized masks.

While the foregoing is directed to embodiments of the present invention, other and further embodiments of the invention may be devised without departing from the basic scope thereof, and the scope thereof is determined by the claims that follow.

## Claims

1. A method of fabricating a photovoltaic cell, comprising:
forming one or more light absorbing layers over a surface of a substrate;
depositing a conductive layer over the one or more light absorbing layers;
forming one or more diagnostic devices on a region of the substrate by removing at least a portion of the conductive layer;
sectioning the substrate into a first and a second section after forming the one or more diagnostic devices, wherein the region is positioned substantially within the first section; and
forming a photovoltaic cell using the one or more light absorbing layers and the conductive layer disposed on the second section of the substrate.

2. The method of claim 1, wherein forming one or more diagnostic devices on the region of the substrate comprises forming a plurality of diagnostic devices that are selected from a group consisting of resistance testers, isolation testers, and photovoltaic cell performance testers.

3. The method according to any of the preceding claims, wherein each of the plurality of formed diagnostic devices are adapted to receive a first contact probe and a second contact probe that are a fixed distance apart, wherein the first and second contact probes are configured to allow an electrical characteristics of at least one of the plurality of diagnostic devices.

4. The method according to any of the preceding claims, wherein forming one or more diagnostic devices on the region of the substrate further comprises forming an alignment scale.

5. A method of fabricating a photovoltaic cell, comprising:
depositing a first conductive layer over a surface of a substrate;
forming one or more light absorbing layers over the first conductive layer;
removing material from the one or more light absorbing layers to form one or more first isolation grooves;
depositing a second conductive layer over the one or more light absorbing layers and the one or more first isolation grooves;
removing a portion of the one or more light absorbing layers and a portion of the second conductive layer to substantially electrically isolate a first region of the one or more light absorbing layers from a second region of the one or more light absorbing layers, and form one or more second isolation grooves that form a third region and a fourth region within the first region which are separated by the one or more second isolation grooves;
measuring the resistance between a point on the second conductive layer in the third region and a point on the second conductive layer in the fourth region; and
adjusting one or more of the process parameters used to form the one or more light absorbing layers or the second conductive layer on a surface of another substrate.

6. The method of claim 5, further comprising removing material from the first region to substantially electrically isolate the third region and the fourth region from a fifth region contained within the first region.

7. The method according to any of claims 5 to 6, further comprising:
sectioning the substrate into a first and a second section, wherein the first region is positioned substantially within the first section; and
forming a photovoltaic cell from at least a portion of the second section.

8. The method according to any of claims 5 to 7, further comprising:
removing material from the first region after depositing the conductive layer to separate a fifth region from the third and the fourth regions; and
measuring the resistance between a first point on the conductive layer in the fifth region and a second point on the conductive layer in the fifth region; and
adjusting one or more of the process parameters used to form the one or more light absorbing layers or the one or more of the process parameters used to form the conductive layer on a surface of another substrate based on the measured resistance in the fifth region.

9. A method of fabricating a photovoltaic cell, comprising:
forming one or more light absorbing layers over a surface of a substrate;
depositing a conductive layer over the one or more light absorbing layers;
forming a first diagnostic device within a first region of the substrate, wherein forming the first diagnostic device comprises:
removing a portion of the one or more light absorbing layers and a portion of the conductive layer to form a second region and a third region within the first region; and forming a second diagnostic device within the first region of the substrate, wherein forming the second diagnostic device comprises:
removing a portion of the deposited one or more light absorbing layers before depositing the conductive layer to form a first groove; and
removing a portion of the one or more light absorbing layers and a portion of the conductive layer to form a fourth region and a fifth region within the first region.

10. The method of claim 9, further comprising:
sectioning the substrate into a first and a second section, wherein the first region is positioned substantially within the first section.

11. The method according to any of claims 9 to 10, further comprising:
measuring the electrical resistance from a point in the second region and a point in the third region, and a point in the fourth region and a point in the fifth region generally simultaneously; and
adjusting one or more of the process parameters used to form the one or more light absorbing layers or the one or more of the process parameters used to form the conductive layer.

12. The method of claim 11, further comprising forming a portion of a photovoltaic cell on a second substrate using the adjusted one or more of the process parameters.

13. A method of fabricating a photovoltaic cell, comprising:
depositing a conductive layer on a surface of a first dielectric substrate;
removing a portion of the deposited conductive layer from the surface of the first dielectric substrate to substantially electrically isolate a first region of the conductive layer from a second region of the conductive layer;
measuring the electrical resistance from a point in the first region and a point in the second region; and
adjusting one or more of the process parameters used of remove the portion of the deposited conductive layer to improve the resistance between a third region and a fourth region formed by removing a portion of a deposited conductive layer disposed on a surface of a second dielectric substrate.

14. The method of claim 13, further comprising sectioning the substrate into a first and a second section, wherein the first and second regions are positioned substantially within the first section.

15. A method of fabricating a photovoltaic cell, comprising:
depositing a first layer on a surface of a first substrate;
removing material from the deposited layer by forming an array of first grooves using a first scribing device;
removing material from the deposited layer by forming an array of second grooves that are positioned adjacent to the array of first grooves using a second scribing device;
analyzing the distance between the array of first grooves and the array of second grooves to determine an offset distance; and
adjusting the position of an array of third grooves formed by the first scribing device or an array of fourth grooves formed by the second scribing device formed in a second substrate based on the determined offset distance.

16. . The method of claim 15, forming a portion of a photovoltaic cell on a second substrate using the adjusted position of the first scribing device or the second scribing device.

17. The method according to any of claims 15 to 16, wherein the distance between the grooves in the array of first grooves is smaller than the distance between the grooves in the array of second grooves.

18. The method according to any of claims 15 to 17, further comprising:
removing material from the deposited layer by forming an array of fifth grooves using a first scribing device, wherein the array of fifth grooves are aligned so that they are orthogonal to the array of first grooves;
removing material from the deposited layer by forming an array of sixth grooves that are positioned adjacent to the array of fifth grooves using a second scribing device, wherein the array of fifth grooves are aligned so that they are orthogonal to the array of sixth grooves ;
analyzing the distance between the array of third grooves and the array of fourth grooves to determine a orthogonal offset distance; and
adjusting the position of the array of third grooves formed by the first scribing device and the array of fourth grooves formed by the second scribing device based on the determined orthogonal offset distance.

19. A method of fabricating a photovoltaic cell, comprising:
forming one or more light absorbing layers over a surface of a substrate;
depositing a conductive layer over the one or more light absorbing layers;
removing a portion of the one or more light absorbing layers and a portion of the conductive layer to separate a first region from a second region on the surface of the substrate;
removing material from the first region to form a third region and a fourth region that are separated by the removed material;
measuring the resistance between a first point on the conductive layer in the third region, and a second point on the conductive layer in the third region or a third point on the conductive layer in the fourth region; and
adjusting one or more of the process parameters used to form the one or more light absorbing layers or the one or more of the process parameters used to form the conductive layer on a surface of another substrate based on the measured resistance.

20. The method of claim 19, further comprising removing material from the first region to substantially electrically isolate the third region and the fourth region from a third region contained within the first region.

21. The method according to any of claims 19 to 20, further comprising:
removing material from the first region after depositing the conductive layer to separate a fifth region from the third and fourth regions; and
measuring the resistance between a first point on the conductive layer in the fifth region and a second point on the conductive layer in the fifth region; and
adjusting one or more of the process parameters used to form the one or more light absorbing layers or the one or more of the process parameters used to form the conductive layer on a surface of another substrate based on the measured resistance in the fifth region.

22. A method of fabricating a photovoltaic cell, comprising:
depositing a first conductive layer over a surface of a substrate;
forming one or more light absorbing layers over the first conductive layer;
depositing a second conductive layer over the one or more light absorbing layers;
forming a testing panel on a first region of the substrate, wherein forming the testing panel comprises forming a plurality of diagnostic devices within the first region of a substrate, wherein the plurality of diagnostic devices are selected from a group consisting of resistance testers, isolation testers, alignment scales, and PV cell performance testers; and
sectioning the substrate into a first and a second section after forming the testing panel.

23. The method of claim 22, wherein each of the plurality of resistance testers, isolation testers, or photovoltaic cell performance testers are adapted to receive a first contact probe and a second contact probe that are a fixed distance apart, wherein the first and second contact probes are configured to allow an electrical characteristics of each of the plurality of resistance testers, isolation testers, and photovoltaic cell performance testers.

24. A testing die used to characterize at least one photovoltaic cell formation processing parameter, comprising:
a quantum efficiency test structure formed on the first region of a substrate; and
a plurality of diagnostic devices that are selected from a group consisting of a resistance tester, an isolation tester, an alignment scale, and an photovoltaic cell performance tester.
